# EUROPÄISCHE PATENTSCHRIFT

(11) **EP 1 012 935 B1**
(45) Veröffentlichungstag und Bekanntmachung des Hinweises auf die Patenterteilung: **14.11.2001**
(21) Anmeldenummer: 98946437.5
(22) Anmeldetag: 27.08.1998
(51) Int. Cl.: H02B 1/30

(54) **REIHE VON ANEINANDERGEREIHTEN SCHALTSCHRÄNKEN**
ROW OF ADJACENT SWITCHGEAR CABINETS
RANGEE D'ARMOIRES DE DISTRIBUTION ADJACENTES

(30) Priorität: 29.08.1997 DE 19737667
(43) Veröffentlichungstag der Anmeldung: 28.06.2000
(73) Patentinhaber: Rittal-Werk Rudolf Loh GmbH & Co. KG, 35745 Herborn (DE)
(72) Erfinder: BENNER, Rolf, D-35745 Herborn (DE); REUTER, Wolfgang, D-57299 Burbach (DE); ROOT, Paul, D-35080 Bad Endbach (DE); KÖHLER, Martina, D-35745 Herborn (DE); MÜNCH, Udo, D-35764 Sinn (DE)
(74) Vertreter: Fleck, Hermann-Josef, Dr.-Ing.
(86) Internationale Anmeldenummer: EP9805452
(87) Internationale Veröffentlichungsnummer: WO9912237

(56) Entgegenhaltungen:
- EP-A- 0 538 540
- WO-A-95/17082
- DE-A- 2 856 443
- US-A- 4 123 129

## Beschreibung

Die Erfindung betrifft eine Reihe von aneinandergereihten Schaltschränken mit einem Rahmengestell, bei der die vertikalen Rahmenschenkel benachbarter Schaltschränke miteinander verbunden und die Boden- und Deckseite der Rahmengestelle mit Boden- und Deckbleche verschlossen sind und bei der die Boden- und Deckbleche zumindest auf den einander zugekehrten Seiten mit Abkantungen versehen sind (Siehe WO-A-9 517 082).

Die EP-A-0 538 540 beschreibt eine Reihe von Schaltschränken, wobei zwischen den vertikalen Rahmenschenkeln der aneinandergereihten Rahmengestelle Zierstreifen angebracht sind.

Die US-A-4 123 129 beschreibt die Aneinanderreihung mehrerer kleingehäuse mittels Verbindungsprofile, die in Eührungsnuten eingeschoben sind.

Die Schaltschränke dieser Art werden auch einzeln aufgestellt, wobei insbesondere die Abkantunaen des Deckbleches eine Art Reaenrinne bildet, die das vom Deckblech ablaufende Regenwasser aufnimmt und an der Vorder -und/oder Rückseite des Schaltschrankes abtropfen läßt. Die Abkantungen sind bei einzeln aufgestelltem Schaltschrank von Vorteil, bei einer Reihe von aneinandergereihten Schaltschränken verschließen sie aber die Stoßstelle zwischen den benachbarten Schaltschränken nicht, so daß sich hier Wasser sammelt und in die Schaltschrank-Innenräume eindringen kann.

Es ist Aufgabe der Erfindung, bei einer Reihe von Schaltschränken der eingangs erwähnten Art die Stoßstellen zwischen benachbarten Schaltschränken auf einfache Art eindeutig zu verschließen, ohne bei der Aufstellung der Schaltschränke als Einzelschrank den Vorteil der guten Wasserableitung über die Abkantungen von Boden- und/oder Deckblech aufgeben zu müssen.

Diese Aufgabe wird nach der Erfindung dadurch gelöst, daß die Abkantungen gegenüber den Außenseiten der aneinanderliegenden vertikalen Rahmenschenkel zurückgesetzt sind und mit Endabschnitten der Abkantungen und/oder Profilseiten der zugekehrten horizontalen Rahmenschenkel eine Art Rinne bilden, die Rinnen im Bereich der Boden- und/oder Deckbleche benachbarter Schaltschränke jeweils mittels eines Abdeckstreifens von der Vorder- bis zur Rückseite der Schaltschränke hin bündig mit den Boden- und/oder Deckblechen verschlossen sind.

Mit den Abdeckstreifen werden die Boden- und/oder Deckseite in bündigen Ebenen abgeschlossen, so daß die Stoßstellen eindeutig abgedichtet sind. Tritt Wasser zwischen dem Abdeckstreifen und dem Boden- und/oder Deckblech ein, dann wird es von den Abkantungen der Deck- und Bodenbleche und den Profilseiten der Rahmenschenkel, aus dem Bereich der Stoßstellen herausge-führt und an der Vorder- und/oder Rückseite der Schaltschränke abgeleitet.

Zum einfachen Anbringen der Abdeckstreifen sieht eine Ausgestaltung vor, daß gegeneinander gerichtete Endabschnitte der Abkantungen von Boden- und/oder Deckblechen benachbarter Schaltschränke im Abstand zueinander stehen und daß die Abdeckstreifen mit einem angeformten Steg zwischen die Endabschnitte ragen und diese hintergreifen.

Die Montage kann dann so ausgeführt werden, daß die Abdeckstreifen quer zu ihrer Längsrichtung in die Rinnen zwischen den Boden- und/oder Deckblechen benachbarter Schaltschränke eingerastet sind oder daß die Abdeckstreifen in ihrer Längsrichtung in die Rinnen zwischen den Boden- und/oder Deckblechen benachbarter Schaltschränke eingeschoben sind.

Einen guten Halt der Abdeckstreifen in den Rinnen benachbarter Boden- und/oder Deckblech wird nach einer Ausgestaltung dadurch erreicht, daß die Endabschnitte zu den Anfangsabschnitten einen spitzen Winkel einnehmen und daß die Stege der Abdeckstreifen als Schwalbenschwanzstege mit entsprechender Neigung ausgebildet sind.

Sind die Abdeckstreifen als Abschnitte eines Kunststoff-Stranges ausgebildet, dann lassen sie sich leicht und kostengünstig im Kunststoff-Extrudierverfahren herstellen. Dabei kann zur Reduzierung der Herstellkosten noch vorgesehen sein, daß die Abdeckstreifen als Abschnitte eines Kunststoff-Stranges ausgebildet sind.

Nach einer weiteren Ausgestaltung lassen sich die Enden der hohlen Abdeckstreifen mittels Abdeckplatten verschließen, die mit angeformten Steckansätzen in Hohlräume der hohlen Abdeckstreifen eingeführt und mittels Paß- und /oder Preßsitz daran gehalten sind.

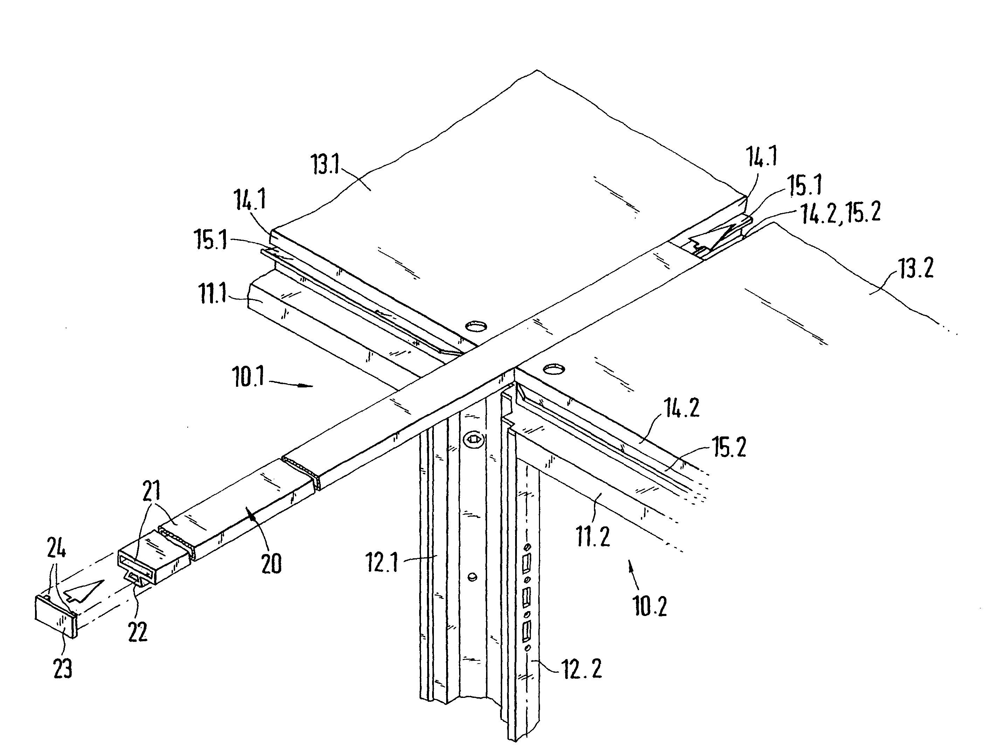

Die Erfindung wird anhand eines in der Zeichnung als perspektivische Teilansicht einer Stoßstelle zwischen den Deckblechen von zwei aneinandergereihten Schaltschränken näher erläutert.

Von der Reihe von aneinandergereihter Schaltschränke 10.1 und 10.2 sind nur Teilbereiche gezeigt, die von dem Rahmengestell des linken Schaltschrankes 10.1 mit den oberen vorderen horizontal verlaufenden Rahmenschenkel 11.1 und den rechten vorderen, vertikal verlaufenden Rahmenschenkel 12.1 erkennen lassen. Von dem rechten Schaltschrank 10.2 ist der obere vordere, horizontal verlaufende Rahmenschenkel 11.2 und der linke vordere, vertikal verlaufende Rahmenschenkel 12.2 zum Teil gezeigt. Im Bereich der Rückseite der beiden Schaltschränke 10.1 und 10.2 stoßen Rahmenschenkel der Rahmengestelle in gleicher Weise aufeinander. Die aneinander anliegenden vertikalen Rahmenschenkel 12.1 und 12.2 benachbarter Schaltschränke 10.1 und 10.2 der Reihe sind fest miteinander verbunden, wozu es verschiedenartige Verbindungselemente gibt.

Die Deckbleche 13.1 und 13.2 der Schaltschränke 10.1 und 10.2 sind ringsum L-förmig abgekantet, wobei die Anfangsabschnitte 14.1 und 14.2 gegenüber den Außenseiten zurückgesetzt sind. Werden die Schaltschränke 10.1 und 10.2 einzeln aufgestellt, dann bilden die Deckbleche 13.1 und 13.2 mit ihren Endabschnitten 15.1 und 15.2 eine Art Regenrinne, die das auf dem Deckblech 13.1 bzw. 13.2 anfallende Regenwasser zur Vorder- und Rückseite des Schaltschrankes 10.1 bzw. 10.2 hin ableiten. Die Regenrinne kann sich über alle Seiten des Deckbleches 13.1 bzw. 13.2 erstrecken und in den Eckbereichen des Deckbleches offen sein.

Sind die Schaltschränke 10.1 und 10.2 aneinandergereiht und fest miteinander verbunden, dann entstehen an den Stoßstelien benachbarter Schaltschränke 10.1 und 10.2 Rinnen, die durch die Abkantungen der Deckbleche 13.1 und 13.2 begrenzt sind. Die Tiefenstreben der aneinandergereihten Rahmengestelle liegen satt aneinander an und werden bis auf den Abstand zwischen den gegeneinander gerichteten Endabschnitten 15.1 und 15.2 der Abkantungen der Deckbleche 13.1 und 13.2 überdeckt.

Um diese Stoßstelle abzudichten, wird ein Abdeckstreifen 20 verwendet, der von der Vorder- bis zur Rückseite der Schaltschränke 10.1 und 10.2 reicht. An der Unterseite des Abdeckstreifens 20 ist ein Steg 22 angeformt, der zwischen die Endabschnitte 15.1 und 15.2 ragt und diese hintergreift, so daß er ohne zusätzliche Befestigungsmittel in der Rinne festgelegt werden kann. Dabei kann der Abdeckstreifen 20 quer zu seiner Längsrichtung in die Rinne eingerastet oder in Längsrichtung in die Rinne eingeschoben und darin gehalten werden.

Der Abdeckstreifen 20 ist ein Abschnitt eines Kunststoff-Stranges, wobei er als Hohlprofil 21 mit angeformtem Steg 22 im Kunststoff-Extrudierverfahren kostengünstig hergestellt werden kann.

Stehen die Endabschnitte 15.1 und 15.2 der Abkantungen im spitzen Winkel zu ihren Anfangsabschnitten 14.1 und 14.2, dann kann der Steg 22 am Abdeckstreifen 20 auch als Schwalbenschwanzsteg ausgebildet sein, der mit seinen Flanken an diesen Winkel angepaßt ist. Der Halt des Abdeckstreifens 20 in der zusammengesetzten Rinne wird dadurch verbessert.

Die Enden der hohlen Abdeckstreifen 20 werden mittels Abdeckplatten 23 verschlossen, die mit angeformten Steckansätzen versehen sind.

Die Steckansätze 24 werden in Hohlräume des Hohlprofiles 21 eingesteckt und mittels Paß- und /oder Preßsitz darin gehalten.

Im Bodenbereich können die Schaltschränke 10.1 und 10.2 mittels Bodenblechen und Abdeckstreifen in gleicher Weise bündig verschlossen werden, wenn dies erforderlich ist.

## Patentansprüche

1. Reihe von aneinandergereihten Schaltschränken (10.1, 10.2) mit einem Rahmengestell, bei der die vertikalen Rahmenschenkel (12.1, 12.2) benachbarter Schaltschränke (10.1, 10.2) miteinander verbunden und die Boden- und Deckseite der Rahmengestelle mit Boden- und Deckbleche (13.1, 13.2) verschlossen sind und bei der die Boden- und Deckbleche (13.1, 13.2) zumindest auf den einander zugekehrten Seiten mit Abkantungen versehen sind,
**dadurch gekennzeichnet, daß** die Abkantungen gegenüber den Außenseiten der aneinanderliegenden vertikalen Rahmenschenkel (12.1, 12.2) zurückgesetzt sind und mit Endabschnitten (15.1, 15.2) der Abkantungen und/oder Profilseiten der zugekehrten horizontalen Rahmenschenkel (11.1, 11.2) eine Art Rinne bilden,
daß die Rinnen im Bereich der Boden- und/oder Deckbleche (13.1; 13.2) benachbarter Schaltschränke (10.1; 10.2) jeweils mittels eines Abdeckstreifens (20) von der Vorder- bis zur Rückseite der Schaltschränke (10.1; 10.2) hin bündig mit den Boden- und/oder Deckblechen (13.1; 13.2) verschlossen sind.

2. Reihe von Schaltschränken nach Anspruch 1,
**dadurch gekennzeichnet,**
**daß** gegeneinander gerichtete Endabschnitte (15.1; 15.2) der Abkantungen von Boden- und/oder Deckblechen (13.1; 13.2) benachbarter Schaltschränke (10.1; 10.2) im Abstand zueinander stehen und
**daß** die Abdeckstreifen (20) mit einem angeformten Steg (22) zwischen die Endabschnitte (15.1; 15.2) ragen und diese hintergreifen.

3. Reihe von Schaltschränken nach Anspruch 2,
**dadurch gekennzeichnet,**
**daß** die Endabschnitte (15.1; 15.2) zu den Anfangsabschnitten (14.1; 14.2) einen spitzen Winkel einnehmen und
**daß** die Stege (22) der Abdeckstreifen (20) als Schwalbenschwanzstege mit entsprechender Neigung ausgebildet sind.

4. Reihe von Schaltschränken nach einem der Ansprüche 1 bis 3,
**dadurch gekennzeichnet,**
**daß** die Abdeckstreifen (20) als Abschnitte eines Kunststoff-Stranges ausgebildet sind.

5. Reihe von Schaltschränken nach Anspruch 4,
**dadurch gekennzeichnet,**
**daß** der Kunststoff-Strang als Hohlprofil (21) ausgebildet ist und daß die Enden des Abdeckstreifens (20) mittels Abdeckplatten (23) verschlossen sind.

6. Reihe von Schaltschränken nach Anspruch 5,
**dadurch gekennzeichnet,**
**daß** die Abdeckplatten (23) angeformte Steckansätze (24) aufweisen, die in Hohlräume des hohlen Abdeckstreifens (20) eingeführt und mittels Paß- oder Preßsitz daran gehalten sind.

7. Reihe von Schaltschränken nach einem der Ansprüche 1 bis 6,
**dadurch gekennzeichnet,**
**daß** die Abdeckstreifen (20) quer zu ihrer Längsrichtung in die Rinnen zwischen den Boden- und/oder Deckblechen (13.1; 13.2) benachbarter Schaltschränke (10.1; 10.2) eingerastet sind.

8. Reihe von Schaltschränken nach einem der Ansprüche 1 bis 6,
**dadurch gekennzeichnet,**
**daß** die Abdeckstreifen (20) in ihrer Längsrichtung in die Rinnen zwischen den Boden- und/oder Deckblechen (13.1; 13.2) benachbarter Schaltschränke (10.1; 10.2) eingeschoben sind.

## Claims

1. Row of adjacent switch cabinets (10.1, 10.2) having a framework, in the case of which the vertical frame legs (12.1, 12.2) of neighbouring switch cabinets (10.1, 10.2) are connected to one another and the bottom side and top side of the frameworks are closed off by bottom and top metal sheets (13.1, 13.2), and in the case of which the bottom and top metal sheets (13.1, 13.2) are provided with bent portions at least on the sides which are directed towards one another, **characterized in that** the bent portions are set back in relation to the outer sides of the adjacent vertical frame legs (12.1, 12.2) and form a type of channel with end sections (15.1, 15.2) of the bent portions and/or profile sides of the facing horizontal frame legs (11.1, 11.2), and **in that** the channels in the region of the bottom and/or top metal sheets (13.1; 13.2) of neighbouring switch cabinets (10.1; 10.2) are closed off flush with the bottom and/or top metal sheets (13.1; 13.2) in each case by means of a covering strip (20) from the front side to the rear side of the switch cabinets (10.1; 10.2).

2. Row of switch cabinets according to Claim 1, **characterized in that** end sections (15.1; 15.2) which belong to the bent portions of bottom and/or top metal sheets (13.1; 13.2) of neighbouring switch cabinets (10.1; 10.2) and are directed towards one another are spaced apart from one another, and **in that** the covering strips (20) project between the end sections (15.1; 15.2), and engage behind the same, by way of an integrally formed crosspiece (22).

3. Row of switch cabinets according to Claim 2, **characterized in that** the end sections (15.1; 15.2) assume an acute angle in relation to the initial sections (14.1; 14.2), and **in that** the crosspieces (22) of the covering strips (20) are designed as dovetail crosspieces with a corresponding inclination.

4. Row of switch cabinets according to one of Claims 1 to 3, **characterized in that** the covering strips (20) are designed as sections of a plastic extrusion.

5. Row of switch cabinets according to Claim 4, **characterized in that** the plastic extrusion is designed as a hollow profile (21), and **in that** the ends of the covering strip (20) are closed off by means of covering plates (23).

6. Row of switch cabinets according to Claim 5, **characterized in that** the covering plates (23) have integrally formed plug-connection extensions (24) which are introduced into cavities of the hollow covering strips (20) and are retained thereon by means of a snug fit or press fit.

7. Row of switch cabinets according to one of Claims 1 to 6, **characterized in that** the covering strips (20) are latched transversely to their longitudinal direction into the channels between the bottom and/or top metal sheets (13.1; 13.2) of neighbouring switch cabinets (10.1; 10.2).

8. Row of switch cabinets according to one of Claims 1 to 6, **characterized in that** the covering strips (20) are pushed in their longitudinal direction into the channels between the bottom and/or top metal sheets (13.1; 13.2) of neighbouring switch cabinets (10.1; 10.2).

## Revendications

1. Rangée d'armoires de commutation (10.1; 10.2) adjacentes, avec un bâti de cadre dans lequel les ailes verticales de cadre (12.1; 12.2) d'armoires de commutation (10.1; 10.2) voisines sont reliées mutuellement et les côtés de fond et de plafond des bâtis de cadre sont fermés par des tôles de fond et de plafond (13.1; 13.2), et dans laquelle les tôles de fond et de plafond (13.1; 13.2) sont dotées de rabats au moins sur les côtés tournés l'un vers l'autre, **caractérisée en ce que** les rabats sont en recul par rapport aux côtés extérieurs des ailes verticales de cadre (12.1; 12.2) adjacentes et forment une sorte de rainure avec des parties d'extrémité (15.1; 15.2) des rabats et/ou des côtés profilés des ailes horizontales de cadre (11.1; 11.2) tournées vers eux, **en ce que** dans la région des tôles de fond et/ou de plafond (13.1; 13.2) d'armoires de commutation (10.1; 10.2) voisines, les rainures sont chacune fermées au moyen d'une latte de recouvrement (20) depuis le côté avant jusqu'au côté arrière des armoires de commutation (10.1; 10.2), à chant avec les tôles de fond et/ou de plafond (13.1; 13.2).

2. Rangée d'armoires de commutation selon la revendication 1, **caractérisée en ce que** des parties d'extrémité (15.1; 15.2) tournées l'une vers l'autre des rabats de tôles de fond et/ou de plafond (13.1; 13.2) d'armoires de commutation (10.1; 10.2) voisines sont situées à distance l'une de l'autre, et **en ce que** les lattes de recouvrement (20) pénètrent par une nervure (22) qui y est formée entre les parties d'extrémité (15.1; 15.2) et s'engagent derrière ces dernières.

3. Rangée d'armoires de commutation selon la revendication 2, **caractérisée en ce que** les parties d'extrémité (15.1; 15.2) forment avec les parties initiales (14.1; 14.2) un angle aigu, et **en ce que** les nervures (22) des lattes de recouvrement (20) sont configurées comme nervures en queue d'aronde d'un angle correspondant.

4. Rangée d'armoires de commutation selon l'une des revendications 1 à 3, **caractérisée en ce que** les lattes de recouvrement (20) sont configurées comme tronçons d'une barre en matière synthétique.

5. Rangée d'armoires de commutation selon la revendication 4, **caractérisée en ce que** la barre en matière synthétique est configurée comme profilé creux (21) et **en ce que** les extrémités de la latte de recouvrement (20) sont fermées au moyen de plaques de recouvrement (23).

6. Rangée d'armoires de commutation selon la revendication 5, **caractérisée en ce que** les plaques de recouvrement (23) présentent des saillies d'enfichage (24) qui y sont formées, qui sont insérées dans les espaces creux de la latte de recouvrement (20) creuse et y sont maintenues par ajustement étroit ou compression.

7. Rangée d'armoires de commutation selon l'une des revendications 1 à 6, **caractérisée en ce que** les lattes de recouvrement (20) sont encliquetées transversalement par rapport au sens de leur longueur dans les rainures situées entre les tôles de fond et/ou de plafond (13.1; 13.2) d'armoires de commutation (10.1; 10.2) voisines.

8. Rangée d'armoires de commutation selon l'une des revendications 1 à 6, **caractérisée en ce que** les lattes de recouvrement (20) sont enfoncées dans le sens de leur longueur dans les rainures situées entre les tôles de fond et/ou de plafond (13.1; 13.2) d'armoires de commutation (10.1; 10.2) voisines.
